# EUROPEAN PATENT APPLICATION

(11) **EP 1 413 615 A1**
(43) Date of publication of application: **28.04.2004**
(21) Application number: 02730861.8
(22) Date of filing: 03.06.2002
(51) Int. Cl.: C09J 7/02

(54) **PRESSURE SENSITIVE ADHESIVE DOUBLE COATED TAPE AND METHOD FOR PRODUCING IC CHIP USING IT**

(30) Priority: 03.08.2001 JP 2001237082; 05.10.2001 JP 2001310543; 15.11.2001 JP 2001350863; 04.12.2001 JP 2001370757; 04.12.2001 JP 2001370759; 04.12.2001 JP 2001370774
(71) Applicant: SEKISUI CHEMICAL CO., LTD., Osaka-shi, Osaka 530-8565 (JP)
(72) Inventor: HATAI, Munehiro c/o Sekisui Chemical Co., Ltd., Mishima-gun, Osaka 618-8589 (JP); FUKUOKA, Masateru c/o Sekisui Chemical Co., Ltd., Mishima-gun, Osaka 618-8589 (JP); HAYASHI, Satoshi c/o Sekisui Chemical Co., Ltd., Mishima-gun, Osaka 618-8589 (JP); DANJO, Shigeru c/o Sekisui Chemical Co., Ltd., Mishima-gun, Osaka 618-8589 (JP); OYAMA, Yasuhiko c/o Sekisui Chemical Co., Ltd., Osaka-shi, Osaka 530-8565 (JP); SHIMOMURA, Kazuhiro c/o Sekisui Chemical Co., Ltd., Hasuda-shi, Saitama 349-0198 (JP); HASEGAWA, Tsuyoshi c/o Sekisui Chemical Co., Ltd., Hasuda-shi, Saitama 349-0198 (JP)
(74) Representative: Hubert, Philippe
(86) International application number: PCT/JP2002/005407
(87) International publication number: WO 2003/014242

(57) **Abstract**

The purpose of the invention is to provide a double-sided adhesive tape which prevents a wafer from damaging even when the wafer has a considerably thin thickness of about 50 µm, which has improved handlability, which is favorably used for processing of an IC chip and which facilitates its peeling, and a method for manufacturing an IC chip using it.

A double-sided adhesive tape containing a gas generating agent for generating a gas by stimulation in at least one side thereof.

## Description

### TECHNICAL FIELD

The present invention relates to a double-sided adhesive tape which prevents a wafer from damaging even when the wafer has a considerably thin thickness of about 50 µm, which is improved handlability, which is favorably used for processing of an IC chip and which facilitates its peeling, and to a method for manufacturing an IC chip using it.

### BACKGROUND ART

A semiconductor integrated circuit (an IC chip) is manufactured as follows. After a semiconductor single crystal with high purity, which is generally in a rod shape, is sliced to form a wafer, a predetermined circuit pattern is formed on the wafer surface using a photoresist. Then, the thickness of the wafer is made as thin as about 100 to 600 µm by grinding the back face of the wafer by a grinder. Finally, the resulting wafer is diced to obtain a chip.

Herein, at the time of the grinding, an adhesive sheet or the like (tape for grinding) is stuck to the wafer surface to prevent the wafer from damaging or facilitate grinding processing. At the time of the dicing, an adhesive sheet or the like (dicing tape) is stuck to the back face side of the wafer to carry out the dicing in the state where the wafer is bonded and fixed. The obtained chip is picked up by being pushed up by needles from the film substrate side of the dicing tape and, then, fixed on a die pad.

Recently, along with the application of IC chips in wide fields, there has been demanded a semiconductor wafer having a considerably thin thickness of about 50 µm, which can be used for IC cards and the like and used by laminating. However, such a semiconductor wafer having a thickness of about 50 µm suffers large warping; therefore, it is easy to be cracked by impact and inferior in its handlability as compared with a conventional semiconductor wafer having a thickness of about 100 to 600 µm. The thin semiconductor wafer is damaged in some cases when it is subjected to processing in the same manner as the conventional semiconductor wafer.

The semiconductor wafer having a thickness of about 50 µm has a high risk of damaging in a grinding step or a dicing step in which the semiconductor wafer tends to receive impact. In addition, the semiconductor wafer is easily damaged at the time of forming bumps on electrodes of an IC chip, resulting in low yield. Therefore, it has been a great challenge to improve the handlability of a wafer in the process of manufacturing an IC chip from a semiconductor wafer having a thickness of about 50 µm.

### SUMMARY OF THE INVENTION

An object of the present invention is to provide a double-sided adhesive tape which prevents a wafer from damaging even when the wafer has a considerably thin thickness of about 50 µm, which has improved handlability, which is favorably used for processing of an IC chip and which facilitates its peeling, and provide a method for manufacturing an IC chip using it.

The present invention provides a double-sided adhesive tape containing a gas generating agent for generating a gas by stimulation in at least one side thereof.

In the double-sided adhesive tape of the present invention, preferably, the gas generating agent does not exist as the form of a particle and may be contained only in a surface part. In addition, the gas generating agent is preferably an azo compound or an azido compound. In particular, the gas generating agent is preferably an azoamido compound represented by the following formula (1) :

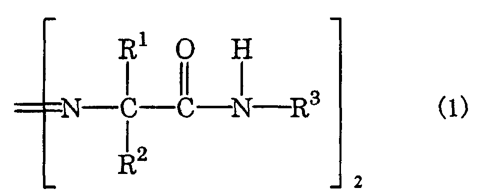

In the formula (1), R¹ and R² are the same or different and each represent a lower alkyl group, and R³ represents a saturated alkyl group having two or more carbon atoms.

In the double-sided adhesive tape of the present invention, preferably, an elastic modulus of an adhesive containing the gas generating agent increases by stimulation and an adhesion decreases by stimulation.

In the double-sided adhesive tape of the present invention, preferably, at least one side thereof is embossed.

In the double-sided adhesive tape of the present invention, at least one side thereof may be made of a water-absorbable adhesive.

The present invention also provides a method for manufacturing an IC chip comprising at least the steps of: fixing a wafer to a supporting plate via the double-sided adhesive tape of the present invention; grinding the wafer in the state of fixing the wafer to the supporting plate via the double-sided adhesive tape; stimulating the double-sided adhesive tape; and peeling off the double-sided adhesive tape from the wafer, the step of fixing the wafer to the supporting plate via the double-sided adhesive tape comprising allowing at least side of the double-sided adhesive tape being stuck to the wafer to contain a gas generating agent.

The present invention also provides method for ° manufacturing an IC chip, comprising at least the steps of: fixing a wafer to a supporting plate via the double-sided adhesive tape of the present invention; grinding the wafer in the state of fixing the wafer is fixed to the supporting plate via the double-sided adhesive tape;
stimulating the double-sided adhesive tape; peeling off the supporting plate from the double-sided adhesive tape stuck to the wafer; and peeling off the double-sided adhesive tape from the wafer, the step of fixing the wafer to the supporting plate via the double-sided adhesive tape comprising allowing at least one side of the double-sided adhesive tape being stuck to the supporting plate to contain a gas generating agent.

The present invention also provides a method for manufacturing an IC chip, comprising at least the steps of: fixing a wafer to a supporting plate via the double-sided adhesive tape; grinding the wafer in the state of fixing the wafer to the supporting plate via the double-sided adhesive tape; stimulating the double-sided adhesive tape; and peeling off the double-sided adhesive tape from the wafer, the step of fixing the wafer to the supporting plate via the double-sided adhesive tape comprising sticking the supporting plate on a side being embossed of the double-sided adhesive.

In this case, preferably, the step of fixing the wafer to the supporting plate via the double-sided adhesive tape comprises sticking the supporting plate on the wafer via the double-sided adhesive tape after the double-sided adhesive tape is stuck to one of the wafer and the supporting plate or in the state of locating the double-sided adhesive tape on a position sticking the supporting plate on the wafer and carrying out a pressure reduction in a vacuum container. In addition, the pressure reduction in the vacuum container is carried out in the state of the wafer and the supporting plate being apart from each other.

The present invention also provides a method for manufacturing an IC chip, comprising at least the steps of: fixing a wafer to a supporting plate via the double-sided adhesive tape; grinding the wafer in the case of fixing the wafer to the supporting plate via the double-sided adhesive tape; stimulating the double-sided adhesive tape; and peeling off the double-sided adhesive tape from the wafer, the step of fixing the wafer to the supporting plate via the double-sided adhesive tape comprising sticking the supporting plate on a side being made of a water-absorbable adhesive of the double-sided adhesive tape, and the sticking the supporting plate on the side made of the water-absorbable adhesive being carried out after the side made of the water-absorbable adhesive is wetted with water and before the water is completely absorbed in the side made of the water-absorbable adhesive.

### BRIEF DESCRIPTION OF THE DRAWING(S)

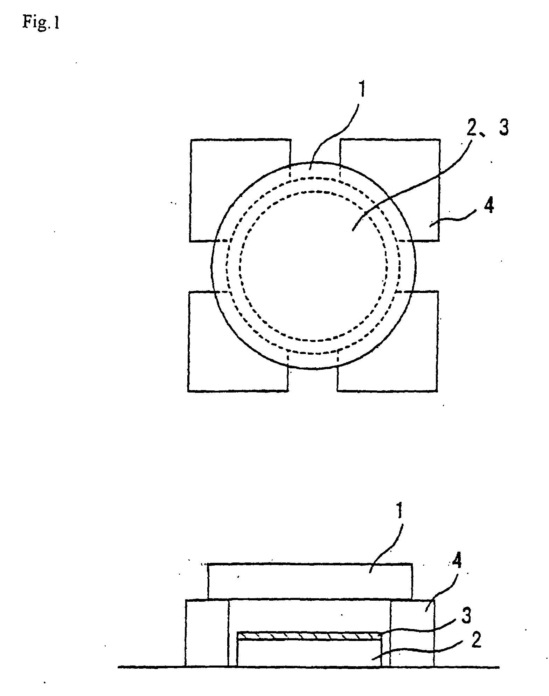

Fig. 1 is a schematic diagram showing an apparatus which reduce a pressure in the state where a wafer and a supporting plate are apart from each other and stick the wafer and the supporting plate to each other in the pressure-reduced state.

In the figure, 1 represents a supporting plate, 2 represents a thick film wafer, 3 represents a supporting tape, and 4 represents a spacer.

### DETAILED DISCLOSURE OF THE INVENTION

A double-sided adhesive tape of the present invention contains a gas generating agent for generating a gas by stimulation in at least one side thereof. The double-sided adhesive tape of the present invention may be a support tape having adhesive layers formed on both sides of a substrate or a non-support tape having no substrate.

The substrate is preferably one through which light transmits or passes in the case where the stimulation for generating a gas from the gas generating agent is stimulation by light, and examples thereof may include sheets of transparent resins such as acrylic, olefin, polycarbonate, vinyl chloride, ABS, polyethylene terephthalate (PET), nylon, urethane and polyimide resins, sheets having a network structure, perforated sheets and the like.

Examples of the stimulation for generating a gas from the gas generating agent may include stimulation by light, heat and ultrasonic wave. In particular, stimulation by light or heat is preferable. Examples of the light may include UV rays, visible light rays and the like. In the case of using stimulation by light as the above stimulation, the adhesive layer containing the gas generating agent is preferably one through which light can transmit or pass.

The gas generating agent for generating gas by the above stimulation is not particularly limited and, for example, azo compounds and azido compounds are preferably used.

Examples of the azo compounds may include 2,2'-azobis(N-cyclohexyl-2-methylpropionamide), 2,2'-azobis(N-(2-methylpropyl)-2-methylpropionamide], 2,2'-azobis(N-butyl-2-methylpripionamide), 2,2'-azobis[N-(2-methylethyl)-2-methylpropionamide], 2,2'-azobis(N-hexyl-2-methylpropionamide), 2,2'-azobis(N-propyl-2-methylpropionamide), 2,2'-azobis(N-ethyl-2-methylpropionamide), 2,2'-azobis{2-methyl-N-[1,1-bis(hydroxymethyl)-2-hydroxyethyl]propionamide}, 2,2'-azobis{2-methyl-N-[2-(1-hydroxybutyl)]propionamide}, 2,2'-azobis[2-methyl-N-(2-hydroxyethyl)propionamide] 2,2'-azobis[N-(2-propenyl)-2-methylpropionamide], 2,2'-azobis[2-(5-methyl-2-imidazolin-2-yl)propane] dihydrochloride, 2,2'-azobis[2-(2-imidazolin-2-yl)propane] dihydrochloride, 2,2'-azobis[2-(2-imidazolin-2-yl)propane] disulfate dihydrate, 2,2'-azobis[2-(3,4,5,6-tetrahydropyrimidin-2-yl)propane] dihydrochloride, 2,2'-azobis{2-[1-(2-hydroxyethyl)-2-imidazolin-2-yl]propane} dihydrochloride, 2,2'-azobis[2-(2-imidazolin-2-yl)propane], 2,2'-azobis(2-methylpropioneamidine) hydrochloride, 2,2,'-azobis(2-aminopropane) dihydrochloride, 2,2'-azobis[N-(2-carboxyacyl)-2-methyl-propioneamidine], 2,2'-azobis{2-[N-(2-carboxyethyl)amidine]propane}, 2,2'-azobis(2-methylpropioneamidoxime), dimethyl-2,2'-azobis(2-methylpropionate), dimethyl-2,2'-azobisisobutylate, 4,4'-azobis(4-cyanecarbonic acid), 4,4'-azobis(4-cyanopentanoic acid), 2,2'-azobis(2,4,4-trimethylpentane) and the like.

In particular, the azoamide compounds represented by the following general formula (1), such as 2,2'-azobis(N-cyclohexyl-2-methylpropionamide), 2,2'-azobis[N-(2-methylpropyl)-2-methylproionamide], 2,2'-azobis(N-butyl-2-methylpropionamide), 2,2'-azobis[N-(2-methylethyl)-2-methylpropionamide], 2,2'-azobis(N-hexyl-2-methylpropionamide), 2,2'-azobis(N-propyl-2-methylpropionamide), 2,2'-azobis(N-ethyl-2-methylpropionamide) and the like, are preferable.

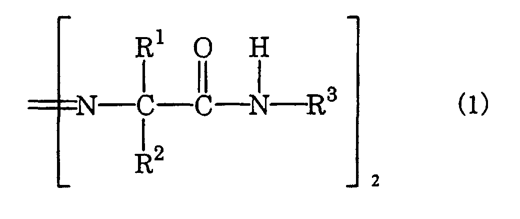

In the formula (1), R¹ and R² each represent a lower alkyl group, and R³ represents a saturated alkyl group having two or more carbon atoms. R¹ and R² may be the same or different from each other.

Since the azoamide compounds represented by the general formula (1) have a high thermal decomposition temperature, they may be subjected to a high temperature treatment performed at the time of manufacturing an IC chip if necessary and they are excellent in solubility in polymers having adhesion property such as acrylic acid alkyl ester polymers which will be described later.

The azo compounds generate nitrogen gas by stimulation by light, heat or the like.

Examples of the azido compounds may include 3-azidomethyl-3-methyloxetane, terephthalazido, p-tert-butylbenzazido and polymers having azido groups such as glycidylazidopolymers obtained by ring-opening polymerization of 3-azidomethyl-3-methyloxetane. These azido compounds generate nitrogen gas by stimulation by light, heat, impact or the like.

Among these gas generating agents, since the azido compounds are easily decomposed by applying impact and thereby emit nitrogen gas, they have a problem that the handling is difficult. Further, once decomposition of the azido compounds starts, chain reactions are caused and the azido compounds explosively emit nitrogen gas beyond control, and therefore, there occurs a problem that the explosively emitted nitrogen gas may cause damages on a wafer. Owing to such a problem, the amount of the use of the azido compounds is limited, however it may be impossible to obtain sufficient effect with a limited use in some cases.

On the other hand, the above-mentioned azo compounds are very easy to handle since, unlike the azido compounds, they do not emit a gas by impact. Further, since they do neither cause chain reactions nor generate a gas explosively and thus the damages on the wafer can be avoided and if light radiation is interrupted, the gas generation is interrupted as well, so that it is possible to control the adhesion based on the application. Accordingly, the azo compounds are more preferable to be used as the gas generating agent.

Addition of the gas generating agent makes it possible to peel at least a part of the adhesion face by the gas generated from the gas generating agent by applying the stimulation to the double-sided adhesive tape and consequent makes it easy to separate an object to which the tape is stuck owing to the decrease of the adhesion strength.

Although the gas generating agent may be included in the entire body of the adhesive layer containing the gas generating agent, if the gas generating agent is included in the entire body of the adhesive layer, the entire body of the adhesive layer becomes a foamed body and so soft as to fail to separate the adhesive layer. Accordingly, the gas generating agent is preferably contained only in the surface part. If the agent is contained only in the surface part, the entire body of the adhesive layer is prevented from becoming a foamed body and gas is generated from the gas generating agent so as to narrow the contact surface area on the stuck face to the object and also the gas separate at least a part of the stuck face of the adhesive layer to the object and lowers the adhesion of the layer.

Incidentally, although it depends on the thickness of the adhesive layer, the surface part preferably means a part to the depth of 20 µm of the adhesive from the surface. Also, that the gas generating agent is contained only in the surface part includes the following state: that the gas generating agent adhering to the adhesive surface is compatible with the adhesive and adsorbed in the adhesive layer or that the gas generating agent evenly adheres to the surface of the adhesive.

Examples of the method for adding the gas generating agent only to the surface part may include: a method for applying an adhesive containing the gas generating agent in a thickness of about 1 to 20 µm to the outermost layer of the double-sided adhesive tape or a method for applying the gas generating agent evenly to the surface by applying a volatile solution containing the gas generating agent to at least one side of a previously produced double-sided adhesive tape or spraying the solution by using a spray. In the case where the gas generating agent is deposited on the surface, it is preferable to deposit the gas generating agent excellent in the compatibility with the adhesive. That is, if a large amount of gas generating agent is deposited on the surface of the adhesive, the adhesion is lowered. However, if the gas generating agent is compatible with the adhesive, the deposited gas generating agent is absorbed in the adhesive layer to prevent decrease of the adhesion and the gas generating agent is diffused to make gas generation even in the entire contact face to the object possible. Further, it is also preferable that the surface part containing the gas generating agent and the remaining are made of resin components with mutually different compositions and it is more preferable that they are made of resin components with different polarity. Consequently, the gas generating agent in the surface part can be prevented from transferring to other parts or is made difficult to transfer to other parts.

The gas generating agent is preferable not to exist as the form of a particle. In this specification, that the gas generating agent does not exist in the form of a particle means that the gas generating agent cannot be seen when a cross section of the adhesive layer containing the gas generating agent is observed by an electron microscope. If the gas generating agent exists in the adhesive layer, light may possibly be scattered in the interface of the particle when the light is radiated as stimulation for generating a gas to decrease the gas generation efficiency and the surface smoothness of the double-sided adhesive tape of the present invention may be deteriorated.

To avoid the existence of the gas generating agent in the form of a particle, in general, a gas generating agent to be dissolved in the adhesive is selected, however in the case where a gas generating agent which is not dissolved in the adhesive is selected, the gas generating agent is finely dispersed in the adhesive by using, for example, a dispersing apparatus or a dispersant in combination.

The gas generating agent is preferably a fine particle. Further, the fine particle is preferably made to be further fine particle, if necessary, by using, for example, a dispersing apparatus or a kneading apparatus. In other words, it is preferable for the gas generating agent to be dispersed to the extent that the agent cannot be seen when an adhesive substance of the present invention is observed by an electron microscope.

In the case where an azido compound or an azo compound is used as a gas generating agent which generates a gas by stimulation by light or the like in the double-sided adhesive tape of the present invention, a photosensitizer is preferable to be added as well. Since the photosensitizer is effective to amplify the stimulation of the gas generating agent by light, a gas can be emitted by radiating a smaller quantity of light rays. Further, since it is made possible to emit the gas owing to the photosensitizer by light in a wider wavelength range, even if the object to stick the tape thereto, which is made of poly(ethylene terephthalate) or the like, does not permeate light with wavelength proper for generating a gas from an azido compound or an azo compound, the gas can be generated by light radiation beyond the object and accordingly the option of materials for the object can be widened.

The photosensitizer is not particularly limited and, for example, a thioxanthone sensitizer or the like is preferable. The thioxanthone sensitizer can be used as a photopolymerization initiator.

The adhesive containing the gas generating agent is preferable those whose elastic modulus increases by stimulation. Further, the adhesive containing the gas generating agent is preferable those whose adhesion decreases by stimulation. The stimulation to increase the elastic modulus of the adhesive or the stimulation to lower the adhesion may be same as or different from the stimulation for generating a gas from the gas generating agent.

Such an adhesive include a photocurable adhesive containing a polymerizable polymer of an alkyl acrylate ester and/or an alkyl methacrylate ester having a radical polymerizable unsaturated bond in a molecule and a radical polymerizable polyfunctional oligomer or monomer as main components and also, based on the necessity, a photopolymerization initiator or a thermosetting adhesive containing a polymerizable polymer of an alkyl acrylate ester and/or an alkyl methacrylate ester having a radical polymerizable unsaturated bond in a molecule and a radical polymerizable polyfunctional oligomer or monomer as main components and also a thermal polymerization initiator.

A post-curable adhesive such as the photocurable adhesive or the thermosetting adhesive quickly and evenly promotes cross-linking polymerization in the entire adhesive layer by light radiation or heating and units the layer and accordingly, the elastic modulus is remarkably increased and the adhesion is considerably decreased by the polymerization curing. Further, when a gas is generated from the gas generating agent in the cured hard substance with increased elastic modulus, almost all of the generated gas is released to the outside and the released gas separates at least a part of the adhesion face of the adhesive from the object and decreases the adhesion strength.

The polymerizable polymer can be obtained by, for example, previously synthesizing a (meth)acrylic polymer having a functional group in a molecule (hereinafter, referred to as a functional group-containing (meth)acrylic polymer) and causing reaction of the polymer with a compound having a unsaturated bond (hereinafter, referred to as a functional group-containing unsaturated compound) in a molecule radical polymerizable and reactive with the functional group.

The functional group-containing (meth)acrylic polymer, as a polymer having an adhesion property at normal temperature, similarly to the case of a common (meth)acrylic polymer, can be obtained by copolymerization of an alkyl acrylate ester and/or an alkyl methacrylate ester of which the alkyl group comprises carbon atoms generally in number of 2 to 18 as a main monomer with a functional group-containing monomer and, if necessary, other modification monomers copolymerizable with the formers. The functional group-containing (meth)acrylic polymer has a weight average molecular weight generally in a range of 200,000 to 2,000,000.

Examples of the functional group-containing monomer include carboxyl-containing monomers such as acrylic acid and methacrylic acid; hydroxyl-containing monomers such as hydroxyethyl acrylate and hydroxyethyl methacrylate; epoxy group-containing monomers such as glycidyl acrylate and glycidyl methacrylate; isocyanate group-containing monomers such as isocyanateethyl acrylate and isocyanateethyl methacrylate; amino group-containing monomers such as aminoethyl acrylate and aminoethyl methacrylate; and the like.

Examples of the copolymerizable modification monomers include various monomers used for common (meth)acrylic polymers such as vinyl acetate, acrylonitrile, styrene and the like.

As the functional group-containing unsaturated compound to be reacted with the functional group-containing (meth)acrylic polymer, similar monomers to the functional group-containing monomers exemplified above may be used, depending on the functional group of the functional group-containing (meth)acrylic polymer. For example, if the functional group of the functional group-containing (meth)acrylic polymer is carboxyl, an epoxy group-containing monomer or an isocyanate group-containing monomer is used, if the functional group of the functional group-containing (meth)acrylic polymer is hydroxyl, an isocyanate group-containing monomer is used and if the functional group is epoxy group, a carboxyl-containing monomer or an amido group-containing monomer such as acrylamide is used and if the functional group is amino group, an epoxy group-containing monomer is used.

As the polyfunctional oligomer or monomer, those having a molecular weight of 10,000 or less are preferable and those having a molecular weight of 5,000 or less and radical polymerizable unsaturated bonds in number of 2 to 20 in a molecule so as to efficiently form a three-dimensional network structure of the adhesive layer by heating or light radiation are more preferable. Examples of such a preferable polyfunctional oligomer or monomer may include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, and similar methacrylates. Additionally, it may further include 1,4-butyleneglycol diacrylate, 1,6-hexanediol diacrylate, polyethyleneglycol diacrylate, commercially available oligoester acrylate and similar methacrylates. These polyfunctional oligomers or monomers may be used alone or two or more of them in combination.

As the photopolymerization initiator, those which can be activated by radiating light with wavelength of 250 to 800 nm can be exemplified, and examples of such a photopolymerization initiator may include: acetophenone derivative compounds such as methoxyacetophenone; benzoin ether type compounds such as benzoin propyl ether and benzoin isobutyl ether; ketal derivative compounds such as benzyl dimethyl ketal and acetophenone diethyl ketal; phosphine oxide derivative compounds; and photo radical polymerization initiators such as bis(η5-cyclopentadienyl)titanocene derivative compound, benzophenone, Michler's ketone, chlorothioxanthone, dodecylthioxanthone, dimethylthioxanthone, diethylthioxanthone, α-hydroxycyclohexyl phenyl ketone, 2-hydroxymethylphenylpropane and the like. These photopolymerization initiator may be used alone or two or more of them in combination.

As the thermal polymerization initiator, those which are decomposed by heat and can give activated radicals starting the polymerization curing can be exemplified, and examples thereof include dicumyl peroxide, di-tert-butyl peroxide, tert-butyl peroxybenzoate, tert-butyl hydroperoxide, benzoyl peroxide, cumene hydroperoxide, diisopropylbenzene hydroperoxide, paramethane hydroperoxide, di-tert-butyl peroxide, and the like. In particular, owing to a high thermal decomposition temperature, cumene hydroperoxide, paramethane hydroperoxide, di-tert-butyl peroxide and the like are preferable. Commercially available products of these thermal polymerization initiators are not particularly limited and Perbutyl D, Perbutyl H, Perbutyl P, Permethane H (all are produced by Nippon Oil & Fats Co., Ltd.) are preferable. These thermal polymerization initiators may be used alone or two or more of them may be used in combination.

For the post-curable adhesive, in order to adjust the cohesion as an adhesive, in addition to the above-mentioned components, a variety of types of polyfunctional compounds such as isocyanate compounds, melamine compounds, epoxy compounds and the like, which are commonly added to the adhesive, may be added properly based on the necessity. Further, well-known additives such as a plasticizer, a resin, a surfactant, wax, a finely granular filler and the like may be added.

Preferably, at least one side of the double-sided adhesive tape of the present invention is subjected to embossing. If the embossing treatment is carried out, the double-sided adhesive tape of the present invention can be stuck to an object with planarity even at a normal pressure. In this specification, the embossing treatment means that irregularity patterns are formed on the surface.

In the case where the gas generating agent is contained only in one side, the embossing treatment is preferably carried out in the side opposed to the side containing the gas generating agent and in the case where the double-sided adhesive tape of the present invention is used for sticking a wafer and supporting plate, the embossing treatment is preferably carried out only on the face of the supporting plate side.

To fabricate a semiconductor wafer as considerably thin as about 50 µm thickness by grinding the wafer, it is important that the wafer is held on a supporting plate with good planarity at the time of grinding. However, in the case where a wafer and a supporting plate are stuck to each other by using a conventional double-sided adhesive tape, unless they are stuck while foams being prevented from entering, so-called air-retention, that is foams are entrained between the double-sided adhesive tape and the supporting plate, takes place occasionally. When the air-retention takes place, since a wafer is lifted up in the part where the air foams are entrained, the wafer shape is strained to make it impossible to obtain a smooth ground face and if the strain is significant, when the stained part is ground, it causes a problem of cracking of the wafer.

Since the double-sided adhesive tape of the present invention is subjected to embossing in at least one side thereof, if the embossed side is stuck to the object, the object is supported by the salient parts of the uneven patterns and foams exist only in the recessed parts of the uneven patterns and therefore the wafer is prevented from being partially lifted up by the foams. Since the embossed side is provided with an even thickness and thus keeps a constant gap between the supporting plate and the wafer, when the wafer is ground while being stuck to the supporting plate, a smoothly ground face can be obtained. Further, as described above, the object is supported by the salient parts of the uneven patterns, so that the uneven patterns work as a cushion and the pressure applied at the time of grinding the wafer can be dispersed to efficiently obtain the wafer with a thinner thickness.

It is required to properly select the intervals of the salient parts of the uneven patterns formed by the embossing treatment and, for example, in the case of fabricating a wafer with a thickness of about 25 µm, they are preferably several hundred µm or less, more preferably 100 µm or less. Since the pressure applied to the parts of the wafer supported by the salient parts of the uneven patterns differs from that applied to the parts of the wafer which are not supported in the case of grinding the wafer stuck to the supporting plate using the above-mentioned double-sided adhesive tape, it may be possible that patterns corresponding to uneven patterns of the double-sided adhesive tape are formed on the wafer after grinding and that grinding becomes uneven in such a manner and consequently, such a problem becomes serious when the thickness of the wafer is made thin. By adjusting the intervals of the uneven patterns to be 100 µm or less, even if the patterns corresponding to the uneven patterns are formed, the grinding unevenness can be suppressed to a problem-free level enough for practical use.

As uneven patterns, random uneven patterns are formed in the entire surface of at least one side of the double-sided adhesive tape of the present invention and of which the salient parts are continuous at several hundred µm or less in almost entire surface and regular uneven patterns can be exemplified. Above all, regularly uneven patterns with salient parts having even height and recessed parts having even depth are preferable as the uneven patterns. Such uneven patterns include those having points, straight lines, arcs and the like are arranged continuously at intervals of several hundred µm or less in the entire face.

The embossing treatment is not particularly limited and the following methods can be exemplified: a method for transferring uneven patterns to an adhesive layer by pressing an emboss sheet, an emboss plate, an emboss roll or the like to the adhesive layer; a method by forming an adhesive layer by applying an adhesive to an embossed face subjected to releasing treatment and then stacking the side which is not embossed of the adhesive layer on a substrate or another adhesive layer; and the like. In order to obtain uneven patterns having salient parts arranged at 100 µm or less intervals, for example, the following methods are applicable: a sand blast method for forming fine uneven patterns by grinding the surface by blowing fine sands; a filler method for forming fine uneven patterns by forming a primer layer containing a fine filler of such as calcium carbonate or the like on the surface and then removing the filler by washing the surface with a solvent which does not dissolve the primer layer but dissolves the filler; and the like.

At least one side of the double-sided adhesive tape of the present invention is preferable made of a water-absorbable adhesive. If the double-sided adhesive tape is stuck to an object after a proper amount of water is dropwise titrated to the face containing such a water-absorbable adhesive, foams are prevented from entering in the adhesion face. In the case where the gas generating agent is contained only in one side, at least the face in the reverse side of the face containing the gas generating agent is preferable to contain the water-absorbable adhesive.

Examples of the water-absorbable adhesive may include a water-dispersible adhesive emulsion such as water-dispersible acrylic adhesive emulsion and a water-dispersible vinyl acetate-based adhesive emulsion; an acrylic adhesive containing a hydrophilic monomer as a constituent monomer; starch glue or the like. These adhesives are easily wetted with water in the surface and can absorb water. Among them, acrylic adhesives containing mainly acrylic acid ester monomers containing hydrophilic monomers such as a carboxyl-containing monomer, an amido group-containing monomer and a hydroxyl-containing monomer as the constituent monomers are preferable since they exhibit excellent cohesion to the adhesion to a wetted face and their surfaces are easily wetted and moderately adsorb water.

The acrylic adhesives containing the hydrophilic monomers as the constituent monomers are not limited to the water-dispersible adhesive emulsions and may include solvent type adhesives and solvent-free type adhesives.

With respect to the acrylic adhesives containing the above-mentioned hydrophilic monomers as the constituent monomers, the acrylic acid ester monomers, the main components, are preferably those comprising alkyl groups with 1 to 14 carbon atoms. Examples of such acrylic adhesives may include methyl (meth)acrylate, ethyl (meth)acrylate, propyl (meth)acrylate, butyl (meth)acrylate, hexyl (meth)acrylate, 2-ethylhexyl (meth)acrylate, heptyl (meth)acrylate, octyl (meth)acrylate, nonyl (meth)acrylate, decyl (meth)acrylate, lauryl (meth)acrylate, octadecyl (meth)acrylate, and the like.

In this specification, (meth)acrylic acid means acrylic acid or methacrylic acid and (meth)acrylate means acrylate or methacrylate.

Examples of the carboxyl-containing monomers may include acrylic acid, methacrylic acid, fumaric acid, maleic acid, itaconic acid, crotonic acid, 2-(meth)acryloyloxyethylsuccinic acid, 2-(meth)acryloyloxyethylphthalic acid, 2-(meth)acryloyloxypropylsuccinic acid, 2-(meth)acryloyloxypropylphthalic acid, 3-(meth)acryloyloxypropionic acid and the like.

Examples of the amido group-containing monomer may include dimethylaminomethyl (meth)acrylate, dimethylaminoethyl (meth)acrylate, N-isoprolylacrylamide, N-vinylpyrrolidone, N-vinylcaprolactam, N-(butoxyl)(meth)acrylamide, (meth)acrylamide, n-alkoxyalkyl unsaturated carboxylicamide, and the like.

Examples of the hydroxyl-containing monomer may include 2-hydroxyethyl (meth)acrylate, 2-hydroxylpropyl (meth)acrylate, 4-hydroxybutyl acrylate, 2-(meth)acryloyloxyethyl hexahydrophthalate, 2-(meth)acryloyloxyethyl tetrahydrophthalate, 2-(meth)acryloyloxypropyl tetrahydrophthalate and the like.

With respect to the acrylic adhesives containing the above-mentioned hydrophilic monomers as constituent monomers, a hydrophilic monomer is preferably contained at a ratio of 1 to 20 parts by weight to 100 parts by weight of an acrylic acid ester monomer, which is a main component.

A dried coating of an adhesive obtained from the water-dispersible adhesive emulsion has water-absorbing property and makes the adhesive surface hydrophilic since the coating contains an emulsifying agent.

As the emulsifying agent, an anionic surfactant or a nonionic surfactant is preferable. Examples of the anionic surfactant may include polyoxyethylene alkyl ether sulfonate, polyoxyethylene alkyl ether sulfate, polyoxyethylene alkyl phenyl ether sulfate, sodium dodecylbenzenesulfonate, sodium laurylsulfate and the like. Further, examples of the nonionic surfactant may include polyoxyethylene alkyl ether, polyoxyethylene alkyl phenyl ether, polyoxyethylene nonyl phenyl ether and the like.

The content of the emulsifying agent is preferably 0.5 to 2 parts by weight to 100 parts by weight of the adhesive resin contained in the water-dispersible adhesive emulsion. If the content of the emulsifying agent is increased, the water-absorbing property and the hydrophilicity of the adhesive surface are improved, however if it is out of the above-mentioned range, the adhesion strength to a wetted face is possibly decreased in some cases.

The water-absorbable adhesive is preferable to be capable of absorbing water and, on the other hand, to be not swollen excessively even if absorbing water. If it is swollen excessively, the thickness of the adhesive layer may possibly become uneven to result in impossibility of holding wafer in planarity.

The application of the double-sided adhesive tape of the present invention is not particularly limited and if it is used in the case of processing a wafer with a thickness as extremely thin as about 50 µm into an IC chip, the wafer is prevented from damages and excellent processibility can be guaranteed.

The wafer may include those made of semiconductors of such as silicon and gallium indium. The thickness of the wafer is not particularly limited and the effect to prevent the damages becomes more significant if the wafer become thinner and in the case where a semiconductor wafer with a thickness of about 50 µm after grinding, for example, with a thickness of 20 to 80 µm, an excellent effect to prevent damages can be exhibited.

The present invention also provides a method for manufacturing an IC chip comprising at least the steps of: fixing a wafer to a supporting plate via the double-sided adhesive tape of the present invention; grinding said wafer in the state of fixing said wafer to said supporting plate via said double-sided adhesive tape; stimulating said double-sided adhesive tape; andpeeling off said double-sided adhesive tape from said wafer, said step of fixing the wafer to the supporting plate via said double-sided adhesive tape comprising allowing at least side of said double-sided adhesive tape being stuck to said wafer to contain a gas generating agent.

In the manufacturing method of an IC chip of the present invention, a wafer is at first fixed to a supporting plate via a double-sided adhesive tape. The wafer to be used in this case is a semiconductor wafer obtained by slicing a high purity silicon single crystal, gallium arsenic single crystal or the like and having a prescribed circuit pattern in the wafer surface and a thickness of about 500 µm to 1 mm. At the time of fixing the wafer to a supporting plate, the double-sided adhesive tape is stuck to the face of the wafer where the circuit is formed.

The supporting plate is not particularly limited and is preferably transparent in the case where the stimulation for generating a gas from the gas generating agent is light and, for example, glass plates and resin plates made of acrylic, olefin, polycarbonate, vinyl chloride, ABS, PET, nylon, urethane, polyimide or other resins can be exemplified.

The supporting plate is preferably subjected to an antistatic treatment. If the supporting plate is charged by static electricity, the plate attracts airborne fine particles to cause adverse effects on the manufacturing of the IC chip. The method for subjecting the supporting plate to the antistatic treatment is not particularly limited and in the case where the stimulation for generating a gas from the gas generating agent is light, a method which can keep the transparency of the supporting plate is preferable. Examples of the method for such antistatic treatment may include a method of adding a transparent conductive plasticizer to the supporting plate, a method for preventing charging by adding a transparent surfactant and increasing the water content in the surface and the like. In particular, a method for forming a conductive resin layer on the surface of a transparent supporting plate by applying a resin dispersion obtained by dispersing a transparent conductive fine particle such as tin oxide fine particle to the surface of the supporting plate is preferable since the method is suitable to obtain a stable antistatic effect while sufficiently keeping the transparency. Unlike a method of adding carbon black or the like, such a method can provide a transparent supporting plate. As such a transparent supporting plate subjected to the antistatic treatment, for example, a DC plate (produced by Sekisui Chemical Co., Ltd.) is commercially available.

In place of the supporting plate subjected to the antistatic treatment, a supporting plate subjected to an electric charge removal treatment may be used. The electric charge removal treatment is not particularly limited and examples thereof may include earthing, ion blowing by an ionizer and the like.

The thickness of the supporting plate is preferably 500 µm to 3 mm, more preferably 1 to 2 mm. The dispersion of the thickness of the supporting plate is preferably in a range of 1% or less.

To fix a wafer to the supporting plate via the double-sided adhesive tape, the gas generating agent-containing face of the double-sided adhesive tape of the present invention is stuck to the wafer. Accordingly, the wafer with a thickness as extremely thin as about 50 µm can be reinforced and therefore, the wafer is prevented from being chipped or cracked when it is transported or processed and the double-sided adhesive tape can easily be peeled off the IC chip by stimulation on completion of a series of IC chip manufacturing steps or during the steps.

Further, in the case of using the double-sided adhesive tape being embossed at least one side thereof is used, the side of the double-sided adhesive tape which is embossed is preferably stuck to the supporting plate. Accordingly, the wafer and the supporting plate can be stuck to each other without entraining the foams.

At the time of sticking the wafer to the supporting plate, it is preferable to stick the wafer and the supporting plate in a reduced pressure in a vacuum container. For example, a thick film wafer and a supporting plate are inserted into a vacuum chamber of a vacuum sticking apparatus and they are preferably stuck to each other via the double-sided adhesive tape in vacuum environments. In this case, when the pressure reduction is carried out while the wafer and the supporting plate being stuck to each other and put in the vacuum container, air removal is possibly prevented by the adhesive and foams may remain in the adhesion face. Accordingly, it is preferable that the pressure reduction is carried out in the state where the thick film wafer and the supporting plate are apart from each other in the vacuum container and after air is sufficiently removed, the thick film wafer and the supporting plate are stuck in the reduced pressure. By carrying out the sticking steps in such vacuum process, foams are not entrained and air-retention is not caused.

Incidentally, to stick the wafer and supporting plate to each other, the sticking process may be carried out after the double-sided adhesive tape of the present invention is stuck to either one of the wafer and the supporting plate or the double-sided adhesive tape of the present invention is located on a position at which the wafer and the supporting plate are stuck to each other and then the wafer and the supporting plate are simultaneously stuck to each other via the double-sided adhesive tape of the present invention in the pressure-reduced state in the vacuum container.

The above-mentioned vacuum sticking apparatus is not particularly limited if the apparatus can carry out the sticking work in vacuum environments, and examples thereof include a vacuum laminator, a vacuum press or the like. The vacuum sticking apparatus is preferable to comprise a means capable of reducing the pressure in the state where the thick film wafer and the supporting plate are apart from each other and sticking the thick film wafer and the supporting plate in the reduced pressure state after sufficiently removing air. Such means is not particularly limited and may be an apparatus, which is installed in the vacuum chamber of the vacuum sticking apparatus, for supporting one of the thick film wafer and the supporting plate by a spacer as shown in Fig. 1. The spacer is preferably those which show no significant volume decrease even in reduced pressure and which can be compressed easily by pressing, and examples thereof may include a spring, an independent foamed body and the like. The above-mentioned spacer is for setting the thick film wafer and the supporting plate in mutually parted state during the pressure reduction and for preventing the break of a wafer by strong collision of the thick film wafer and the supporting plate at the time of sticking. In the vacuum sticking apparatus comprising such means, either the thick film wafer or the supporting plate is supported by the spacer and the pressure reduction is carried out in the state that both are apart from each other and after air is sufficiently removed, a press apparatus is moved in the reduced pressure and the thick film wafer and the supporting plate are stuck to each other while the spacer being compressed.

Further, in the case of using a double-sided adhesive tape of which at least one side contains a water-absorbable adhesive, the face of the double-sided adhesive tape which contains the water-absorbable adhesive and the supporting plate are stuck to each other and in the case of sticking the face containing the water-absorbable adhesive and the supporting plate to each other, it is preferable to stick them after the side containing the water-absorbable adhesive is wetted with water and before the water is completely absorbed in the side containing the water-absorbable adhesive. Accordingly, when the supporting plate and the face containing the water-absorbable adhesive are stuck to each other, since a water layer exists between them, the supporting plate and the double-sided adhesive tape can closely be stuck by the surface tension of water and air entrainment between them (air-retention) can be prevented. By such a manner, the wafer and the supporting plate can also be stuck without entraining foams.

When the side of the double-sided adhesive tape which contains the water-absorbable adhesive and the supporting plate are stuck to each other, since a water film is spread to the entire face to wet the face owing to the surface tension of water and the sticking pressure, air entrainment is prevented if at least the center part of the face is wetted. However it is preferable to wet almost entire surface of the face. Consequently, the entire surface of the adhesion face is wet with water when the tape and the supporting plate are stuck to each other and air entrainment can efficiently be prevented.

When the supporting plate is stuck to the face of double-sided adhesive tape which contains the water-absorbable adhesive, it is preferable to stick the supporting plate successively from one end. Consequently, while the water film on the surface being pushed back, the sticking is carried out and thus the air entrainment can effectively be prevented. Further, if the face containing the water-absorbable adhesive absorbs so much quantity of water and is wetted to a far extent, the surface becomes too soft and the thickness of the adhesive layer may be dispersed, and therefore, at the time of sticking, it is preferable to push out the water film on the surface as much as possible so as to carry out the sticking and to suppress the quantity of water remaining in the adhesion face.

If a water film is formed on the surface, correction of the sticking position is relatively easy unless sticking is carried out so strongly and the sticking position can easily be adjusted.

In the manufacturing method of an IC chip of the present invention, the wafer is ground while being fixed to the supporting plate via the double-sided adhesive tape. By fixing the wafer to the supporting plate via the double-sided adhesive tape of the present invention, the wafer is prevented from damaging during the grinding process. Further, as described above, since air-retention hardly takes place, the wafer can smoothly be ground.

Successively, stimulation is applied to the double-sided adhesive tape. By applying stimulation for generating a gas from the above-mentioned gas generating agent, the gas generated from the gas generating agent is released to the adhesion face between the double-sided adhesive tape and the object to lower the cohesion in order to peel at least a part of the adhesion face. If the adhesive forming the face containing the gas generating agent is those whose elastic modulus is increased by the stimulation, the stimulation which can increase the elastic modulus of the adhesive is preferably applied to increase the elastic modulus of the adhesive before the gas is generated from the gas generating agent. Accordingly, emission of the gas generated from the gas generating agent to the adhesion face from the adhesive is promoted and further decrease the cohesion.

The present invention also provides a method for manufacturing an IC chip, comprising at least the steps of: fixing a wafer to a supporting plate via the double-sided adhesive tape according of present invention; grinding said wafer in the state of fixing said wafer is fixed to said supporting plate via said double-sided adhesive tape; stimulating said double-sided adhesive tape;peeling off said supporting plate from said double-sided adhesive tape stuck to said wafer; and peeling off said double-sided adhesive tape from said wafer, said step of fixing the wafer to the supporting plate via said double-sided adhesive tape comprising allowing at least one side of said double-sided adhesive tape being stuck to said supporting plate to contain a gas generating agent. In the case of using the double-sided adhesive tape of which the side stuck to the supporting plate contains the gas generating agent, prior to separation of the double-sided adhesive tape from the wafer, a gas is generated from the gas generating agent between the supporting plate and the double-sided adhesive tape by applying stimulation to lower the cohesion and if the hard supporting plate is separated from the double-sided adhesive tape and the hard supporting plate is separated from the double-sided adhesive tape, the double-sided adhesive tape becomes a flexible tape and the tape can be separated from the wafer and the tape can be separated from the wafer while the tape being turned over, and therefore it is preferable since the tape can further easily be separated from the wafer.

In a common process, before the wafer is separated by generating a gas by applying stimulation on completion of the grinding step, a dicing tape is stuck to the ground wafer and then the wafer is subjected to dicing after separation.

In the manufacturing method of an IC chip of the present invention, if necessary, the steps carried out commonly can be omitted or the order of the steps may be different from the order of common steps and, for example, the grinding step may be carried out after previous dicing to make a wafer in chip-like state.

### BEST MODE FOR CARRYING OUT THE INVENTION

The present invention will be described in detail with reference to the following examples; however, the present invention is not limited to these examples.

### (Example 1)

### <Preparation of adhesive>

The following compounds were dissolved in ethyl acetate and UV was radiated to carry out polymerization and obtain an acrylic copolymer with a weight average molecular weight of 700,000.

To 100 parts by weight of a resin solid content in the obtained ethyl acetate solution containing the acrylic copolymer, 2-isocyanateethyl methacrylate 3.5 parts by weight was added to cause reaction and further to 100 parts of the resin solid content of the obtained ethyl acetate solution after the reaction,
pentaerythritol triacrylate 20 parts by weight, a photopolymerization initiator (Irgacure 651, 50% ethyl acetate solution) 0.5 parts by weight, and polyisocyanate 1.5 parts by weight were added to produce an ethyl acetate solution of an adhesive (1).

| | |
|---|---|
| Butyl acrylate | 79 parts by weight |
| Ethyl acrylate | 15 parts by weight |
| Acrylic acid | 1 part by weight |
| 2-Hydroxyethyl acrylate | 5 parts by weight |
| Photopolymerization initiator | 0.2 parts by weight |
| (Irgacure 651, 50% ethyl acetate solution) | |
| Laurylmercaptan | 0.02 parts by weight |

To 100 parts by weight of the resin solid content of the ethyl acetate solution of the adhesive (1), 2,2'-azobis-(N-butyl-2-methylpropionamide) 100 parts by weight was added to produce an adhesive (2) containing a gas generating agent.

### <Production of double-sided adhesive tape>

The ethyl acetate solution containing the adhesive (2) was applied to a polyethylene terephthlate (PET) film whose surface was subjected to release treatment by a doctor knife so as to form a film with a thickness in dried film state of about 10 µm and heated at 110°C for 5 minutes to dry the coating solution. The adhesive layer after drying showed adhesion property in dried state. Next, a PET film whose surface was subjected to release treatment was stuck to the surface of the adhesive (2) layer. After that, the resulting body was left still and cured at 40°C for 3 days.

The ethyl acetate solution containing the adhesive (1) was applied to a transparent PET with a thickness of 100 µm film whose both faces were subjected to corona treatment by a doctor knife so as to form a film with a thickness in dried film state of about 15 µm and heated at 110°C for 5 minutes to dry the coating solution. The adhesive layer after drying showed adhesion property in dried state. Next, an embossed PET (PTH-38, salient part intervals 40 µm, produced by Unitika Co.) whose surface was subjected to release treatment was pushed against the surface of the adhesive (1) layer to form uneven patterns on the surface of the adhesive (1) layer. After that, the resulting body was left still and cured at 40°C for 3 days.

The ethyl acetate solution containing the adhesive (1) was applied to a transparent PET film whose surface was subjected to release treatment by a doctor knife so as to form a film with a thickness in dried film state of about 15 µm and heated at 110°C for 5 minutes to dry the coating solution. The adhesive layer after drying showed adhesion property in dried state. Next, a PET film whose surface was subjected to release treatment was stuck to the surface of the adhesive (1) layer. After that, the resulting body was left still and cured at 40°C for 3 days.

Next, with respect to the corona-treated PET film on which the adhesive (1) layer is formed, the face subjected to corona treatment and bearing no adhesive (1) layer was stuck to the face of the adhesive (1) layer of the PET film subjected to release treatment and bearing the adhesive (1) layer. Accordingly, a double-sided adhesive tape bearing the adhesive layers in both faces and whose surface was protected with the PET film subjected to release treatment was obtained.

After the PET film protecting the surface of the adhesive (1) layer of the double-sided adhesive tape in the side where no embossing treatment was carried out and whose surface was subjected to release treatment was peeled off, the surface in which the adhesive (2) layer was formed was stuck to the adhesive (2) layer of the PET film whose surface was subjected to release treatment. Accordingly, a double-sided adhesive tape 1 whose surface was protected by the PET film subjected to release treatment for the surface and of which one side was coated with an adhesive (1) layer subjected to embossing and whose the other face was coated with a primer layer of the adhesive (2) in the surface layer of the adhesive (1) layer was obtained.

### <Manufacturing of IC chip>

### (Sticking silicon wafer and glass plate to each other)

The PET film protecting the adhesive (2) layer of the double-sided adhesive tape 1 was peeled off and the tape was stuck to a silicon wafer with a diameter of 20 cm and a thickness of about 750 µm. Next, the PET film for protecting the adhesive (1) layer subjected to the embossing treatment was peeled off and the resulting tape was stuck to a glass plate with a diameter of 20.4 cm.

### (Grinding step)

The silicon wafer reinforced by the glass plate was set in a grinding apparatus and ground until the thickness of the silicon wafer became about 50 µm. The silicon wafer was taken out the grinding apparatus and a dicing tape was stuck to the silicon wafer.

### (UV radiation step)

Using a ultrahigh pressure mercury lamp, UV rays of 365 nm were radiated for 2 minutes to the surface of the glass plate from the glass plate side while the illuminance being controlled so as to adjust the radiation intensity of 40 mW/cm².

### (Wafer separation step)

The silicon wafer was fixed and the glass plate was pulled right upward and separated together with the double-sided adhesive tape from the silicon wafer. The double-sided adhesive tape was pushed upward and lifted up by a generated gas and spontaneously separated.

### (Dicing step)

Successively, the silicon wafer reinforced by a dicing tape was attached to a dicing apparatus and cut into an IC chip size by inserting a cutter blade from the wafer side. Next, the IC chip was separated from the dicing tape to take the IC chip.

### (Example 2)

### <Preparation of adhesive>

The following compounds were dissolved in ethyl acetate and UV was radiated to carry out polymerization and obtain an acrylic copolymer with a weight average molecular weight of 700,000.

To 100 parts by weight of a resin solid content in the obtained ethyl acetate solution containing the acrylic copolymer, 2-isocyanateethyl methacrylate 3.5 parts by weight was added to cause reaction and further to 100 parts of the resin solid content of the obtained ethyl acetate solution after the reaction, pentaerythritol triacrylate 40 parts by weight, a photopolymerization initiator (Irgacure 651) 5 parts by weight, and polyisocyanate 0.5 parts by weight were added to produce an ethyl acetate solution of an adhesive (3).

| | |
|---|---|
| Butyl acrylate | 79 parts by weight |
| Ethyl acrylate | 15 parts by weight |
| Acrylic acid | 1 part by weight |
| 2-Hydroxyethyl acrylate | 5 parts by weight |
| Photopolymerization initiator | 0.2 parts by weight |
| (Irgacure 651, 50% ethyl acetate solution) | |
| Laurylmercaptan | 0.01 parts by weight |

To 100 parts by weight of the resin solid content of the ethyl acetate solution of the adhesive (3), 2,2'-azobis-(N-butyl-2-methylpropionamide) 30 parts by weight and 2,4-diethylthioxanthone 3.6 parts by weight were added to produce an adhesive (4) containing a gas generating agent.

### <Production of double-sided adhesive tape>

The ethyl acetate solution containing the adhesive (3) was applied to a transparent PET film with a thickness of 100 µm whose both faces were subjected to corona treatment by a doctor knife so as to form a film with a thickness in dried film state of about 15 µm and heated at 110°C for 5 minutes to dry the coating solution. The adhesive layer after drying showed adhesion property in dried state. Next, an embossed PET (EM-38, salient part intervals 600 µm, produced by Unitika Co.) whose surface was subjected to release treatment was pushed against the surface of the adhesive (3) layer to form uneven patterns in the surface of the adhesive (3) layer. After that, the resulting body was left still and cured at 40°C for 3 days.

The ethyl acetate solution containing the adhesive (4) was applied to a transparent PET film whose surface was subjected to release treatment by a doctor knife so as to form a film with a thickness in dried film state of about 50 µm and heated at 110°C for 5 minutes to evaporate a solvent and dry the coating solution. The adhesive layer after drying showed adhesion property in dried state. Next, a PET film whose surface was subjected to release treatment was stuck to the surface of the adhesive (4) layer. After that, the resulting body was left still and cured at 40°C for 3 days.

Next, with respect to the corona-treated PET film on which the adhesive (3) layer is formed, the face subjected to corona treatment and bearing no adhesive (3) layer was stuck to the face of the adhesive (4) layer of the PET film subjected to release treatment and bearing the adhesive (4) layer. Accordingly, a double-sided adhesive tape 2 bearing the adhesive layers in both faces and whose surface was protected with the PET film subjected to release treatment was obtained.

### <Manufacturing of IC chip>

The PET film protecting the adhesive (4) layer of the double-sided adhesive tape 2 was peeled off and the tape was stuck to a silicon wafer with a diameter of 20 cm and a thickness of about 750 µm. Next, the PET film for protecting the adhesive (3) layer subjected to embossing was peeled off and the resulting tape was stuck to a glass plate with a diameter of 20.4 cm

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 3)

### <Production of double-sided adhesive tape>

The ethyl acetate solution containing the adhesive (3) produced in Example 2 was applied to one face of a transparent PET with a thickness of 100 µm film whose both faces were subjected to corona treatment by a doctor knife so as to form a film with a thickness in dried film state of about 15 µm and heated at 110°C for 5 minutes to dry the coating solution. Next, a PET subjected to release treatment was stuck to the surface of the adhesive (3) layer. The adhesive layer after drying showed adhesion property in dried state. After that, the resulting body was left still and cured at 40°C for 3 days.

The ethyl acetate solution containing the adhesive (4) produced in Example 2 was applied to a transparent PET film whose surface was subjected to release treatment by a doctor knife so as to form a film with a thickness in dried film state of about 50 µm and heated at 110°C for 5 minutes to evaporate the solvent and dry the coating solution. The adhesive layer after drying showed adhesion property in dried state. Next, a PET film whose surface was subjected to release treatment was stuck to the surface of the adhesive (4) layer. After that, the resulting body was left still and cured at 40°C for 3 days.

Next, with respect to the corona-treated PET film on which the adhesive (3) layer is formed, the face subjected to corona treatment and bearing no adhesive (3) layer was stuck to the face of the adhesive (4) layer of the PET film subjected to release treatment and bearing the adhesive (4) layer. Accordingly, a double-sided adhesive tape 3 bearing the adhesive layers in both faces and whose surface was protected with the PET film subjected to release treatment was obtained.

### <Manufacturing of IC chip>

Using an apparatus illustrated in Fig. 1 and installed in a vacuum chamber of a vacuum laminator (Vacuum Applicator 724, produced by Nichigo-Morton Co., Ltd), a silicon wafer and a glass plate were stuck to each other by the following method. The vacuum laminator comprises the vacuum chamber provided with a press apparatus capable of carrying out pressing process in the up and down directions: the press apparatus comprises a fixed press plate in the down face and a press plate in the top face which is expanded just like a balloon by air pressure so as to lower a supporting plate fixed therein. As the spacer of the apparatus illustrated in Fig. 1, an independently foamed body of a polyolefin resin was used.

At first, the PET film protecting the adhesive (4) layer of the double-sided adhesive tape 3 was separated and the double-sided adhesive tape 3 was stuck to the silicon wafer with a diameter of 20 cm and a thickness of about 750 µm and after the resulting silicon wafer was set at a prescribed position of the apparatus illustrated in Fig. 1 and installed in the vacuum chamber of the vacuum laminator, the PET film protecting the adhesive (3) layer was separated. Next, a glass plate with a diameter of 20.4 cm was set at a prescribed position of the apparatus illustrated in Fig. 1. In such a state, the air in the vacuum chamber was discharged to keep the inside of the chamber in vacuum environment and after that, the balloon of the top face was expanded to lower the glass plate to stick the silicon wafer and the glass plate.

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 4)

### <Production of double-sided adhesive tape>

The ethyl acetate solution containing the adhesive (1) produced in Example 1 was applied to one face of a transparent PET with a thickness of 12 µm film whose both faces were subjected to corona treatment by a doctor knife so as to form a film with a thickness in dried film state of about 30 µm and heated at 110°C for 5 minutes to dry the coating solution. Next, a PET film subjected to release treatment was stuck to the surface of the adhesive (1) layer. After that, the resulting body was left still and cured at 40°C for 3 days.

The ethyl acetate solution containing the adhesive (1) was applied to a transparent PET film whose surface was subjected to release treatment by a doctor knife so as to form a film with a thickness in dried film state of about 30 µm and heated at 110°C for 5 minutes to evaporate the solvent and dry the coating solution. The adhesive layer after drying showed adhesion property in dried state. Next, a PET film whose surface was subjected to release treatment was stuck to the surface of the adhesive (1) layer. After that, the resulting body was left still and cured at 40°C for 3 days.

Next, with respect to the corona-treated PET film on which the adhesive (1) layer is formed, the face subjected to corona treatment and bearing no adhesive (1) layer was stuck to the face of the adhesive (1) layer of the PET film subjected to release treatment and bearing the adhesive (1) layer.

Further, after the PET film subjected to release treatment and protecting the adhesive (1) layer was separated, a methyl ethyl ketone solution containing 5% by weight of 2,2'-azobis-(N-butyl-2-methylpropioneamide) was evenly sprayed to the surface of the adhesive (1) layer until the surface of the adhesive (1) layer was sufficiently wetted. After the spraying was repeated three times, heating was carried out at 110°C for 5 minutes. Accordingly, pale yellow precipitated particles of 2,2' -azobis-(N-butyl-2-methylpropioneamide) were deposited on the surface of the adhesive (1) layer.

Next, a PET film subjected to release treatment was stuck to the surface of the adhesive (1) layer bearing the precipitated particles to push in the precipitated particles and obtain a double-sided adhesive tape 4. The precipitated particles deposited on the adhesive surface were dissolved and absorbed in the adhesive after a while.

### <Manufacturing of IC chip>

Using the double-sided adhesive tape 4, the adhesive (1) layer bearing precipitated particles was stuck to a silicon wafer and the adhesive (1) layer was stuck to a glass plate and similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 5)

### <Production of double-sided adhesive tape>

The ethyl acetate solution containing the adhesive (2) produced in Example 1 was applied to a polyethylene terephthlate (PET) film whose surface was subjected to release treatment by a doctor knife so as to form a film with a thickness in dried film state of about 10 µm and heated at 110°C for 5 minutes to dry the coating solution. The adhesive layer after drying showed adhesion property in dried state. Next, an embossed PET (PTH-38, salient part intervals 40 µm, produced by Unitika Co.) whose surface was subjected to release treatment was pushed against the surface of the adhesive (2) layer to form uneven patterns in the surface of the adhesive (2) layer. After that, the resulting body was left still and cured at 40°C for 3 days.

The ethyl acetate solution containing the adhesive (1) was applied to one face of a transparent PET with a thickness of 100 µm film whose both faces were subjected to corona treatment by a doctor knife so as to form a film with a thickness in dried film state of about 15 µm and heated at 110°C for 5 minutes to dry the coating solution. The adhesive layer after drying showed adhesion property in dried state. Next, a PET film whose surface was subjected to release treatment was stuck to the surface of the adhesive (1) layer. After that, the resulting body was left still and cured at 40°C for 3 days.

The ethyl acetate solution containing the adhesive (1) was applied to a transparent PET film whose surface was subjected to release treatment by a doctor knife so as to form a film with a thickness in dried film state of about 15 µm and heated at 110°C for 5 minutes to dry the coating solution. The adhesive layer after drying showed adhesion property in dried state. Next, a PET film whose surface was subjected to release treatment was stuck to the surface of the adhesive (1) layer. After that, the resulting body was left still and cured at 40°C for 3 days.

Next, with respect to the corona-treated PET film on which the adhesive (1) layer is formed, the face subjected to corona treatment and bearing no adhesive (1) layer was stuck to the face of the adhesive (1) layer of the PET film subjected to release treatment and bearing the adhesive (1) layer. Accordingly, a double-sided adhesive tape bearing the adhesive layers in both faces and whose surface was protected with the PET film subjected to release treatment was obtained.

After the PET film for protecting the adhesive (1) layer and whose surface was subjected to release treatment was peeled off, the surface of the adhesive (2) layer of the double-sided adhesive tape in one side was stuck to the face which is in the side where no embossing treatment was carried out and which is of the adhesive (2) layer formed on the PET film subjected to release treatment. Accordingly, a double-sided adhesive tape 5 of which the surface was protected by the PET film whose surface was subjected to release treatment and which comprises a primer layer of the embossed adhesive (2) in the surface layer part of the adhesive (1) layer in one side face and the adhesive (1) layer in the other side face is obtained.

### <Manufacturing of IC chip>

The PET film protecting the adhesive (1) layer of the double-sided adhesive tape 5 was peeled off and the tape was stuck to a silicon wafer with a diameter of 20 cm and a thickness of about 750 µm. Next, the PET film for protecting the adhesive (2) layer was peeled off and the resulting tape was stuck to a glass plate with a diameter of 20.4 cm.

### (Grinding step)

The silicon wafer reinforced by the glass plate was set in a grinding apparatus and ground until the thickness of the silicon wafer became about 50 µm. The silicon wafer was taken out the grinding apparatus and a dicing tape was stuck to the silicon wafer.

### (UV radiation step)

Using a ultrahigh pressure mercury lamp, UV rays of 365 nm were radiated for 2 minutes to the surface of the glass plate from the glass plate side while the illuminance being controlled so as adjust the radiation intensity of 40 mW/cm².

### (Glass plate separation step)

The silicon wafer was fixed and then the glass plate was separated from the double-sided adhesive tape. The glass plate was pushed upward and lifted up by a generated gas and spontaneously separated.

### (Wafer separation step)

The double-sided adhesive tape was separated by gripping an end of the double-sided adhesive tape and turning over the tape.

### (Dicing step)

Successively, the silicon wafer reinforced by a dicing tape was attached to a dicing apparatus and cut into an IC chip size by inserting a cutter blade from the wafer side. Next, the IC chip was separated from the dicing tape to take the IC chip.

### (Example 6)

### <Production of double-sided adhesive tape>

The ethyl acetate solution containing the adhesive (1) produced in Example 1 was applied to a polyethylene terephthlate (PET) film whose surface was subjected to release treatment by a doctor knife so as to form a film with a thickness in dried film state of about 40 µm and heated at 110°C for 5 minutes to dry the coating solution. A PET film whose surface was subjected to release treatment was stuck to the surface of the former PET film.

Further, a PET film protecting the adhesive (1) layer and whose surface was subjected to release treatment was peeled off and a methyl ethyl ketone solution containing 5% by weight of 2,2'-azobis-(N-butyl-2-methylpropionamide) was evenly sprayed to the surface of the adhesive (5) layer until the surface of the adhesive (5) layer was sufficiently wetted. After the spraying was repeated three times, heating was carried out at 110°C for 5 minutes. Accordingly, pale yellow precipitated particles of 2,2'-azobis-(N-butyl-2-methylpropionamide) were deposited on the surface of the adhesive (1) layer.

Next, a PET film subjected to release treatment was stuck to the surface of the adhesive (1) layer bearing the precipitated particles to push the precipitated particles therein and obtain a non-support type double-sided adhesive tape 6. The precipitated particles deposited on the adhesive surface were dissolved and absorbed in the adhesive after a while.

### <Manufacturing of IC chip>

Using the double-sided adhesive tape 6, the adhesive (1) layer bearing precipitated particles of the double-sided adhesive tape 6 was stuck to a silicon wafer and the adhesive (2) layer was stuck to a glass plate and similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 7)

### <Production of double-sided adhesive tape>

The ethyl acetate solution containing the adhesive (2) was applied to a PET film whose surface was subjected to release treatment by a doctor knife so as to form a film with a thickness in dried film state of about 10 µm and heated at 110°C for 5 minutes to dry the coating solution. The adhesive layer after drying showed adhesion property in dried state. Next, a PET film whose surface was subjected to release treatment was stuck to the surface of the adhesive (2) layer.

The ethyl acetate solution containing the adhesive (1) was applied to a transparent PET with a thickness of 100 µm film and whose both faces were subjected to corona treatment by a doctor knife so as to form a film with a thickness in dried film state of about 15 µm in one face of the PET film and heated at 110°C for 5 minutes to dry the coating solution. The adhesive layer after drying showed adhesion property in dried state. Next, a PET film whose surface was subjected to release treatment was stuck to the surface of the adhesive (1).

The ethyl acetate solution containing the adhesive (1) was applied to a transparent PET film whose surface was subjected to release treatment by a doctor knife so as to form a film with a thickness in dried film state of about 15 µm and heated at 110°C for 5 minutes to evaporate the solvent and dry the coating solution. The adhesive layer after drying showed adhesion property in dried state. Next, a PET film whose surface was subjected to release treatment was stuck to the surface of the adhesive (1) layer.

Next, with respect to the corona-treated PET film on which the adhesive (1) layer was formed, the face subjected to corona treatment and bearing no adhesive (1) layer was stuck to the face of the adhesive (1) layer of the PET film subjected to release treatment and bearing the adhesive (1) layer. Accordingly, a double-sided adhesive tape bearing the adhesive layers in both faces and whose surface was protected with the PET film subjected to release treatment was obtained.

After the PET film protecting the surface of the adhesive (1) layer of the double-sided adhesive tape was peeled off and then stuck to the adhesive (2) layer of the PET film which was coated with the adhesive (2) layer and whose surface was subjected to release treatment. After that the obtained body was kept still and cured at 40°C for 3 days. Accordingly, a double-sided adhesive tape 7 whose surface was protected by the PET film subjected to release treatment for the surface and of which one side was coated with an adhesive (1) layer and whose the other face was coated with a primer layer of the adhesive (2) in the surface layer of the adhesive (1) layer was obtained.

### <Manufacturing of IC chip>

Using an apparatus illustrated in Fig. 1 and installed in a vacuum chamber of a vacuum laminator (Vacuum Applicator 724, produced by Nichigo-Morton CO.), a silicon wafer and a glass plate were stuck to each other by the following method. The vacuum laminator comprises the vacuum chamber provided with a press apparatus capable of carrying out pressing process in the up and down directions: the press apparatus comprises a fixed press plate in the down face and a press plate in the top face which is expanded just like a balloon by air pressure so as to lower a supporting plate fixed therein. As the spacer of the apparatus illustrated in Fig. 1, an independently foamed body of a polyolefin resin was used.

At first, the PET film protecting the adhesive (2) layer of the double-sided adhesive tape 7 was separated and the supporting tape was stuck to the silicon wafer with a diameter of 20 cm and a thickness of about 750 µm and after the resulting silicon wafer was set at a prescribed position of the apparatus illustrated in Fig. 1 and installed in the vacuum chamber of the vacuum laminator, the embossed PET film protecting the adhesive (1) layer was separated. Next, a glass plate with a diameter of 20.4 cm was set at a prescribed position of the apparatus illustrated in Fig. 1. In such a state, the air in the vacuum chamber was discharged to keep the inside of the chamber in vacuum environment and after that, the balloon of the top face was expanded to lower the glass plate to stick the silicon wafer and the glass plate.

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 8)

### <Preparation of adhesive>

The following compounds were loaded into a flask equipped with a refluxing cooling apparatus, a stirrer, a thermometer, and a titration funnel and a xylene solution containing benzoyl peroxide (obtained by mixing benzoyl peroxide 0.05 parts by weight and xylene 3.7 parts by weight) was dropwise titrated and at the moment when reaction was carried out for 30 minutes under refluxing condition, a diluted xylene solution containing benzoyl peroxide (obtained by mixing benzoyl peroxide 0.03 parts by weight and xylene 3 parts by weight) was dropwise titrated. When reaction was carried out for 5 hours, a diluted xylene solution containing benzoyl peroxide (obtained by mixing benzoyl peroxide 0.03 parts by weight and xylene 3 parts by weight) was again dropwise titrated and aging was carried out for 2 hours. To 100 parts by weight of resin solid content of the obtained ethyl acetate solution of the acrylic adhesive, polyisocyanate 1 part by weight was added to produced an ethyl acetate solution of the adhesive (5).

| | |
|---|---|
| Butyl acrylate | 38 parts by weight |
| 2-Ethylhexyl acrylate | 55 parts by weight |
| Ethyl acrylate | 4 parts by weight |
| Acrylamide | 3 parts by weight |
| Ethyl acetate | 85 parts by weight |

On the other hand, the following compounds were dissolved in ethyl acetate and UV was radiated to carry out polymerization and obtain an acrylic copolymer with a weight average molecular weight of 700,000.

To 100 parts by weight of a resin solid content in the obtained ethyl acetate solution containing the acrylic copolymer, pentaerythritol triacrylate 20 parts by weight, benzophenone 0.5 parts by weight, and polyisocyanate 0.3 parts by weight were added to produce an ethyl acetate solution of an adhesive (6).

| | |
|---|---|
| Butyl acrylate | 79 parts by weight |
| Ethyl acrylate | 15 parts by weight |
| Acrylic acid | 1 part by weight |
| 2-Hydroxyethyl acrylate | 5 parts by weight |
| Photopolymerization initiator | 0.2 parts by weight |
| (Irgacure 651, 50% ethyl acetate solution) | |
| Laurylmercaptan | 0.01 parts by weight |

To 100 parts by weight of the resin solid content of the ethyl acetate solution of the adhesive (6), 2,2'-azobis-(N-butyl-2-methylpropionamide) 100 parts by weight was added to produce an adhesive (7) containing a gas generating agent.

### <Production of double-sided adhesive tape>

The ethyl acetate solution containing the adhesive (5) was applied to one face of a transparent PET film with a thickness of 12 µm and whose both faces were subjected to corona treatment by a doctor knife so as to form a film with a thickness in dried film state of about 30 µm and heated at 110°C for 5 minutes to dry the coating solution. The adhesive layer after drying showed adhesion property in dried state. Next, a PET film subjected to release treatment was stuck to the surface of the adhesive (5) layer. After that, the resulting body was left still and cured at 40°C for 3 days.

The ethyl acetate solution containing the adhesive (7) was applied to a transparent PET film whose surface was subjected to release treatment by a doctor knife so as to form a film with a thickness in dried film state of about 30 µm and heated at 110°C for 5 minutes to evaporate the solvent and dry the coating solution. The adhesive layer after drying showed adhesion property in dried state. Next, a PET film subjected to release treatment was stuck to the surface of the adhesive (7) layer. After that, the resulting body was left still and cured at 40°C for 3 days.

Next, with respect to the corona-treated PET film on which the adhesive (5) layer was formed, the face subjected to corona treatment and bearing no adhesive (5) layer was stuck to the face of the adhesive (7) layer of the PET film bearing the adhesive (7) layer. Accordingly, a double-sided adhesive tape 8 having the adhesive layers in both faces and whose surface was protected by the PET films whose surface was subjected to release treatment. Both of the adhesive layers of the double-sided adhesive tape 8 were transparent.

### <Manufacturing of IC chip>

The PET film protecting the adhesive (7) layer was peeled off the double-sided adhesive tape 8 cut into a circular shape with a diameter of 20 cm and the tape was stuck to a silicon wafer of a diameter of 20 cm and a thickness of about 750 µm. Next, the PET film protecting the adhesive (5) layer was peeled off and water was supplied so as to form a water film in almost entire face of the adhesive (5) layer and then, a glass plate with a diameter of 20.4 cm was gradually stuck from the end of the adhesive layer while pushing out the water film. In this case, the sticking step was carried out while the positioning was corrected in such a manner that the center of the glass plate and the center of the silicon wafer coincide with each other. Since the water film was formed on the surface of the adhesive, the positioning correction was found to be easy if the sticking was not carried out so strongly and thus the effect to easily carry out the sticking positioning adjustment can be provided by forming the water film on the surface of the adhesive. When the adhesion face was observed via the glass plate, since the adhesion was carried out while pushing out water, no foam entrainment was observed in the adhesion face and since almost all of the water was pushed out, even the water remaining in the adhesion face was absorbed in the adhesive after a while. The adhesion face showed strong adhesion strength even immediately after the adhesion.

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 9)

### <Production of double-sided adhesive tape>

The ethyl acetate solution containing the adhesive (5) was applied to one face of a transparent PET film with a thickness of 12 µm and whose both faces were subjected to corona treatment by a doctor knife so as to form a film with a thickness in dried film state of about 30 µm and heated at 110°C for 5 minutes to dry the coating solution. The adhesive layer after drying showed adhesion property in dried state. Next, a PET film subjected to release treatment was stuck to the surface of the adhesive (5) layer. After that, the resulting body was left still and cured at 40°C for 3 days.

The ethyl acetate solution containing the adhesive (6) was applied to a transparent PET film whose surface was subjected to release treatment by a doctor knife so as to form a film with a thickness in dried film state of about 30 µm and heated at 110°C for 5 minutes to evaporate the solvent and dry the coating solution. The adhesive layer after drying showed adhesion property in dried state. Next, a PET film subjected to release treatment was stuck to the surface of the adhesive (6) layer. After that, the resulting body was left still and cured at 40°C for 3 days.

Next, with respect to the corona-treated PET film on which the adhesive (5) layer was formed, the face subjected to corona treatment and bearing no adhesive (5) layer was stuck to the face of the adhesive (6) layer of the PET film bearing the adhesive (6) layer. Accordingly, a double-sided adhesive tape P having the adhesive layers in both faces and whose surface was protected by the PET films whose surface was subjected to release treatment was obtained.

The ethyl acetate solution containing the adhesive (7) produced in Example 8 was applied to a transparent PET film whose surface was subjected to release treatment by a doctor knife so as to form a film with a thickness in dried film state of about 10 µm and heated at 110°C for 5 minutes to dry the coating solution. The adhesive layer after drying showed adhesion property in dried state. Next, a PET film subjected to release treatment was stuck to the surface of the adhesive (7) layer. After that, the resulting body was left still and cured at 40°C for 3 days.

The PET film protecting the adhesive (5) layer of the above-mentioned double-sided adhesive tape P and whose surface was subjected to release treatment was peeled off and the adhesive (5) layer and the adhesive (7) layer of the PET film bearing the adhesive (7) layer were stuck to each other.

Accordingly, a double-sided adhesive tape 9 of which the adhesive layers were protected by the PET film subjected to release treatment for the surface and which was provided with a primer layer of the adhesive (7) in the surface layer of the adhesive (6) layer was obtained.

### <Manufacturing of IC chip>

Using the double-sided adhesive tape 9, the adhesive (7) layer of the double-sided adhesive tape 9 was stuck to a silicon wafer and the adhesive (5) layer was stuck to a glass plate.

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 10)

### <Production of double-sided adhesive tape>

The PET film protecting the adhesive (6) layer of the double-sided adhesive tape P produced in Example 9 and whose surface was subjected to release treatment was peeled off and a methyl ethyl ketone solution containing 5% by weight of 2,2'-azobis-(N-butyl-2-methylpropionamide) was sprayed to the extent that the surface of the adhesive (6) layer was sufficiently wetted. After the spraying was repeated three times, heating was carried out at 110°C for 5 minutes. Accordingly, pale yellow precipitated particles of 2,2'-azobis-(N-butyl-2-methylpropionamide) were deposited on the surface of the adhesive (6) layer.

Next, a PET film subjected to release treatment was stuck to the surface of the adhesive (6) layer bearing the precipitated particles to push in the precipitated particles and obtain a double-sided adhesive tape 10. The precipitated particles adhering to the adhesive surface were dissolved and absorbed in the adhesive after a while.

### <Manufacturing of IC chip>

Using the double-sided adhesive tape 10, the adhesive (6) layer bearing precipitated particles of the double-sided adhesive tape 10 was stuck to a silicon wafer and the adhesive (5) layer was stuck to a glass plate.

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Example 11)

### <Preparation of adhesive>

To 100 parts by weight of resin solid content of the ethyl acetate solution of the adhesive (6) prepared in Example 8, 100 parts by weight of 2,2'-azobis-(N-butyl-2-methylpropionamide) was added to produce an adhesive (8) containing a gas generating agent.

### <Production of double-sided adhesive tape>

The ethyl acetate solution containing the adhesive (8) was applied to one face of a PET film with a thickness of 12 µm and whose both faces were subjected to corona treatment by a doctor knife so as to form a film with a thickness in dried film state of about 30 µm and heated at 110°C for 5 minutes to dry the coating solution. The adhesive layer after drying showed adhesion property in dried state. Next, a PET film subjected to release treatment was stuck to the surface of the adhesive (8) layer. After that, the resulting body was left still and cured at 40°C for 3 days.

The ethyl acetate solution containing the adhesive (6) prepared in Example 8 was applied to a transparent PET film whose surface was subjected to release treatment by a doctor knife so as to form a film with a thickness in dried film state of about 30 µm and heated at 110°C for 5 minutes to dry out the solvent. The adhesive layer after drying showed adhesion property in dried state.

Next, with respect to the corona-treated PET film on which the adhesive (8) layer was formed, the face subjected to corona treatment and bearing no adhesive (8) layer was stuck to the face of the adhesive (6) layer of the PET film bearing the adhesive (6) layer. Accordingly, a double-sided adhesive tape 11 having the adhesive layers in both faces and whose surface was protected by the PET films whose surface was subjected to release treatment was obtained.

### <Manufacturing of IC chip>

A silicon wafer was fixed to a glass plate and a grind step was carried out in the same manner as that of Example 1, except that using the double-sided adhesive tape 11, the adhesive (6) layer of the double-sided adhesive tape 11 was stuck to a silicon wafer and the adhesive (6) layer was stuck to a glass plate.

After UV radiation was carried out for 1 minute, the silicon wafer was fixed and the glass plate was separated from the double-sided adhesive tape. Incidentally, the glass plate was pushed upward and lifted up by a generated gas from the double-sided adhesive tape and spontaneously separated. Next, after UV radiation was carried out for 1 minute, the double-sided adhesive tape was peeled in such a manner that an end of the double-sided adhesive tape was gripped and slowly turned over. Finally the obtained silicon wafer was subjected to dicing step.

### (Example 12)

### <Production of double-sided adhesive tape>

The ethyl acetate solution containing the adhesive (8) produced in Example 11 was applied to a PET film whose surface was subjected to release treatment by a doctor knife so as to form a film with a thickness in dried film state of about 10 µm and heated at 110°C for 5 minutes to dry the coating solution. The adhesive layer after drying showed adhesion property in dried state. Next, a PET film whose surface was subjected to release treatment was stuck to the surface of the adhesive (8) layer. After that, the resulting body was left still and cured at 40°C for 3 days.

On the other hand, the ethyl acetate solution containing the adhesive (6) was applied to one face of a transparent PET with a thickness of 12 µm film and whose both faces were subjected to corona treatment by a doctor knife so as to form a film with a thickness in dried film state of about 30 µm and heated at 110°C for 5 minutes to dry the coating solution. The adhesive layer after drying showed adhesion property in dried state. Next, a PET film whose surface was subjected to release treatment was stuck to the surface of the adhesive (6). After that, the resulting body was left still and cured at 40°C for 3 days.

The ethyl acetate solution containing the adhesive (6) was applied to the surface of a transparent PET film subjected to release treatment by a doctor knife so as to form a film with a thickness in dried film state of about 30 µm and heated at 110°C for 5 minutes to evaporate the solvent and dry the coating solution. The adhesive layer after drying showed adhesion property in dried state. Next, a PET film subjected to release treatment was stuck to the surface of the adhesive (6) layer. After that, the resulting body was left still and cured at 40°C for 3 days.

Next, with respect to the corona-treated PET film on which the adhesive (6) layer was formed, the face subjected to corona treatment and bearing no adhesive (6) layer was stuck to the face of the adhesive (6) layer of the PET film bearing the adhesive (6) layer. Accordingly, a double-sided adhesive tape bearing the adhesive layers in both faces and whose surface was protected with the PET film subjected to release treatment was obtained.

After the PET film protecting the surface of the adhesive (6) layer of the double-sided adhesive tape was peeled off and then stuck to the adhesive (8) layer of the PET film which was coated with the adhesive (8) layer and whose surface was subjected to release treatment.

Accordingly, a double-sided adhesive tape 12 whose surface was protected by the PET film subjected to release treatment for the surface and which was provided with a primer layer containing the adhesive (8) in the surface layer of the adhesive (6) layer was obtained.

### <Manufacturing of IC chip>

A silicon wafer was fixed to a glass plate and a grind step was carried out in the same manner as that of Example 1, except that using the double-sided adhesive tape 12, the adhesive (6) layer of the double-sided adhesive tape 12 was stuck to a silicon wafer and the adhesive (8) layer was stuck to a glass plate.

After UV radiation was carried out for 1 minute, the silicon wafer was fixed and the glass plate was separated from the double-sided adhesive tape. Incidentally, the glass plate was pushed upward and lifted up by a generated gas from the double-sided adhesive tape and spontaneously separated. Next, after UV radiation was carried out for 1 minute, the double-sided adhesive tape was peeled in such a manner that an end of the double-sided adhesive tape was gripped and slowly turned over. Finally the obtained silicon wafer was subjected to dicing step.

### (Example 13)

### <Production of double-sided adhesive tape>

The ethyl acetate solution containing the adhesive (6) was applied to one face of a transparent PET film with a thickness of 12 µm whose both faces were subjected to corona treatment by a doctor knife so as to form a film with a thickness in dried film state of about 30 µm and heated at 110°C for 5 minutes to dry the coating solution. The adhesive layer after drying showed adhesion property in dried state. Next, a PET film subjected to release treatment was stuck to the surface of the adhesive (6) layer. After that, the resulting body was left still and cured at 40°C for 3 days.

The ethyl acetate solution containing the adhesive (6) was applied to a transparent PET whose surface was subjected to release treatment by a doctor knife so as to form a film with a thickness in dried film state of about 30 µm and heated at 110°C for 5 minutes to evaporate the solvent and dry the coating solution. The adhesive layer after drying showed adhesion property in dried state. Next, a PET film subjected to release treatment was stuck to the surface of the adhesive (6). After that, the resulting body was left still and cured at 40°C for 3 days.

Next, with respect to the corona-treated PET film on which the adhesive (6) layer was formed, the face subjected to corona treatment and bearing no adhesive (6) layer was stuck to the face of the adhesive (6) layer of the PET film bearing the adhesive (6) layer. Accordingly, a double-sided adhesive tape bearing the adhesive layers in both faces and whose surface was protected with the PET film subjected to release treatment was obtained.

After the PET film protecting the surface of the adhesive (6) layer in one side of the double-sided adhesive tape was peeled off and then a methyl ethyl ketone solution containing 5% by weight of 2,2'-azobis-(N-butyl-2-methylpropionamide) was evenly sprayed to the surface of the adhesive (2) layer until the surface of the adhesive (2) layer was sufficiently wetted. After the spraying was repeated three times, heating was carried out at 110°C for 5 minutes. Accordingly, pale yellow precipitated particles of 2,2'-azobis-(N-butyl-2-methylpropionamide) were deposited on the surface of the adhesive (6) layer.

Next, a PET film subjected to release treatment was stuck to the surface of the adhesive (6) layer bearing the precipitated particles to push in the precipitated particles and obtain a double-sided adhesive tape 13.

### <Manufacturing of IC chip>

A silicon wafer was fixed to a glass plate and a grind step was carried out in the same manner as that of Example 1, except that using the double-sided adhesive tape 13, the adhesive (6) layer of the double-sided adhesive tape 13 was stuck to a silicon wafer and the adhesive (6) layer bearing the precipitated particles was stuck to a glass plate.

After UV radiation was carried out for 1 minute, the silicon wafer was fixed and the glass plate was separated from the double-sided adhesive tape. Incidentally, the glass plate was pushed upward and lifted up by a generated gas from the double-sided adhesive tape and spontaneously separated. Next, after UV radiation was carried out for 1 minute, the double-sided adhesive tape was peeled in such a manner that an end of the double-sided adhesive tape was gripped and slowly turned over. Finally the obtained silicon wafer was subjected to dicing step.

### (Example 14)

### <Preparation of adhesive>

To 100 parts by weight of the resin solid content of the ethyl acetate solution containing the adhesive (1), 100 parts by weight of 3-azidomethyl-3-methyloxetane was added to produce an adhesive (9) containing a photodecomposable azido compound.

### <Production of double-sided adhesive tape>

The ethyl acetate solution containing the adhesive (9) was applied to a PET film whose surface was subjected to release treatment by a doctor knife so as to form a film with a thickness in dried film state of about 10 µm and heated at 110°C for 5 minutes to dry the coating solution. The adhesive layer after drying showed adhesion property in dried state. Next, a PET film whose surface was subjected to release treatment was stuck to the surface of the adhesive (9) layer.

The ethyl acetate solution containing the adhesive (1) was applied to one face of a transparent PET with a thickness of 100 µm film and whose both faces were subjected to corona treatment by a doctor knife so as to form a film with a thickness in dried film state of about 15 µm and heated at 110°C for 5 minutes to dry the coating solution. The adhesive layer after drying showed adhesion property in dried state. Next, an embossed PET film whose one side was subjected to release treatment was stuck to the surface of the adhesive (1) layer, while the face where the uneven patterns of the PET film being strongly pushed. Accordingly the uneven patterns were transferred to the surface of the adhesive (1) layer.

The ethyl acetate solution containing the adhesive (1) was applied to the surface of a transparent PET film subjected to release treatment by a doctor knife so as to form a film with a thickness in dried film state of about 15 µm and heated at 110°C for 5 minutes to evaporate the solvent and dry the coating solution. The adhesive layer after drying showed adhesion property in dried state. Next, a PET film subjected to release treatment was stuck to the surface of the adhesive (1) layer.

Next, with respect to the corona-treated PET film on which the adhesive (1) layer was formed, the face subjected to corona treatment and bearing no adhesive (1) layer was stuck to the face of the adhesive (1) layer of the PET film bearing the adhesive (1) layer. After that, the resulting body was left still and cured at 40°C for 3 days. Accordingly, a double-sided adhesive tape bearing the adhesive layers in both faces and whose surface was protected with the PET film subjected to release treatment was obtained.

After the PET film protecting the surface of the adhesive (1) layer of the double-sided adhesive tape in the side where the embossing treatment was not carried out was peeled off and then stuck to the adhesive (2) layer of the PET film which was coated with the adhesive (2) layer and whose surface was subjected to release treatment. Accordingly, a double-sided adhesive tape 14 whose one side was coated with the embossed adhesive (1) layer and whose the other face was coated with a primer layer containing the adhesive (9) on the surface layer part of the adhesive (1) layer was obtained.

### <Manufacturing of IC chip>

The PET film protecting the adhesive (9) layer of the double-sided adhesive tape 14 was peeled and stuck to a silicon wafer with a diameter of 20 cm and a thickness of about 750 µm. Next, the PET film protecting the adhesive (1) layer which was embossed was peeled and stuck to a glass plate with a diameter of 20 cm.

Similarly to Example 1, the grinding step, the UV radiation step, the wafer separating step, and the dicing step were carried out to obtain an IC chip. Incidentally, in the wafer separation step, the double-sided adhesive tape was pushed upward and lifted up by a generated gas and spontaneously separated.

### (Evaluation of capability of each double-sided adhesive tape in manufacturing of IC chip)

In a case of using any one of the double-sided adhesive tapes produced in the examples, with respect to the adhesion to a supporting plate, no foam entrainment was observed in the adhesion face and a high cohesion was obtained even immediately after the adhesion and a silicon wafer with smooth ground face was obtained. An adhesive containing a gas generating agent is remarkably excellent in lowering the cohesion and thus a silicon wafer or a glass plate could easily be separated.

Further, in Examples 5, 11, 12 and 13 in which the glass plates were separated at first, the double-sided adhesive tapes could be peeled off very easily from the silicon wafers.

### INDUSTRIAL APPLICABILITY

According to the present invention, it is possible to provide a double-sided adhesive tape which prevents a wafer from damaging even when the wafer has a considerably thin thickness of about 50 µm, which has improved handlability, which is favorably used for processing of an IC chip and which facilitates its peeling, and to a method for manufacturing an IC chip using it.

## Claims

1. A double-sided adhesive tape containing a gas generating agent for generating a gas by stimulation in at least one side thereof.

2. The double-sided adhesive tape according to claim 1,
wherein the gas generating agent does not exist as the form of a particle.

3. The double-sided adhesive tape according to claim 1 or 2,
wherein the gas generating agent is an azo compound.

4. The double-sided adhesive tape according to claim 3,
wherein the azo compound is an azoamide compound represented by the following formula (1): 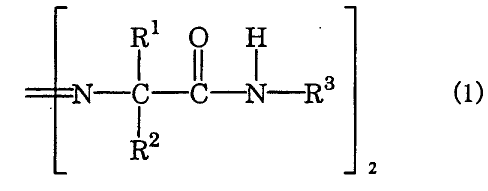 in the formula (1), R¹ and R² are the same or different and each represent a lower alkyl group, and R³ represents a saturated alkyl group having two or more carbon atoms.

5. The double-sided adhesive tape according to claim 1 or 2,
wherein the gas generating agent is an azido compound.

6. The double-sided adhesive tape according to claim 1, 2, 3, 4 or 5,
wherein the gas generating agent is contained only in a surface part.

7. The double-sided adhesive tape according to claim 1, 2, 3, 4, 5 or 6,
wherein an elastic modulus of an adhesive containing the gas generating agent increases by stimulation.

8. The double-sided adhesive tape according to claim 1, 2, 3, 4, 5, 6 or 7,
wherein an adhesion of the adhesive containing the gas generating agent decreases by stimulation.

9. The double-sided adhesive tape according to claim 1, 2, 3, 4, 5, 6, 7 or 8,
wherein at least one side thereof is embossed.

10. The double-sided adhesive tape according to claim 1, 2, 3, 4, 5, 6, 7 or 8,
wherein at least one side thereof is made of a water-absorbable adhesive.

11. A method for manufacturing an IC chip comprising at least the steps of:
fixing a wafer to a supporting plate via the double-sided adhesive tape according to claim 1, 2, 3, 4, 5, 6, 7, 8, 9 or 10;
grinding said wafer in the state of fixing said wafer to said supporting plate via said double-sided adhesive tape;
stimulating said double-sided adhesive tape; and
peeling off said double-sided adhesive tape from said wafer,
said step of fixing the wafer to the supporting plate via said double-sided adhesive tape comprising allowing at least side of said double-sided adhesive tape being stuck to said wafer to contain a gas generating agent.

12. A method for manufacturing an IC chip, comprising at least the steps of:
fixing a wafer to a supporting plate via the double-sided adhesive tape according to claim 1, 2, 3, 4, 5, 6, 7, 8, 9 or 10;
grinding said wafer in the state of fixing said wafer is fixed to said supporting plate via said double-sided adhesive tape;
stimulating said double-sided adhesive tape;
peeling off said supporting plate from said double-sided adhesive tape stuck to said wafer; and
peeling off said double-sided adhesive tape from said wafer,
said step of fixing the wafer to the supporting plate via said double-sided adhesive tape comprising allowing at least one side of said double-sided adhesive tape being stuck to said supporting plate to contain a gas generating agent.

13. The method for manufacturing an IC chip according to claim 11 or 12, comprising at least the steps of:
fixing a wafer to a supporting plate via the double-sided adhesive tape according to claim 9;
grinding said wafer in the state of fixing said wafer to said supporting plate via said double-sided adhesive tape;
stimulating said double-sided adhesive tape; and
peeling off said double-sided adhesive tape from the wafer,
said step of fixing the wafer to the supporting plate via said double-sided adhesive tape comprising sticking the supporting plate on a side being embossed of said double-sided adhesive.

14. The method for manufacturing an IC chip according to claim 11, 12 or 13,
wherein said step of fixing the wafer to the supporting plate via the double-sided adhesive tape comprises sticking said supporting plate on said wafer via the double-sided adhesive tape after said double-sided adhesive tape is stuck to one of said wafer and said supporting plate or in the state of locating said double-sided adhesive tape on a position sticking said supporting plate on said wafer and carrying out a pressure reduction in a vacuum container.

15. The method for manufacturing an IC chip according to claim 14,
wherein the pressure reduction in the vacuum container is carried out in the state of said wafer and said supporting plate being apart from each other.

16. The method for manufacturing an IC chip according to claim 11 or 12, comprising at least the steps of:
fixing a wafer to a supporting plate via the double-sided adhesive tape according to claim 10;
grinding said wafer in the case of fixing said wafer to said supporting plate via said double-sided adhesive tape;
stimulating said double-sided adhesive tape; and
peeling off said double-sided adhesive tape from the wafer,
said step of fixing the wafer to the supporting plate via said double-sided adhesive tape comprising sticking the supporting plate on a side being made of a water-absorbable adhesive of said double-sided adhesive tape, and the sticking the supporting plate on the side made of said water-absorbable adhesive being carried out after the side made of said water-absorbable adhesive is wetted with water and before water is completely absorbed in the side made of said water-absorbable adhesive.
